# EUROPEAN PATENT APPLICATION

(11) **EP 1 353 368 A1**
(43) Date of publication of application: **15.10.2003**
(21) Application number: 02290902.2
(22) Date of filing: 11.04.2002
(51) Int. Cl.: H01L 21/74

(54) **Semiconductor structure and method for manufacturing the same**

(71) Applicant: AMI Semiconductor Belgium BVBA, 9700 Oudenaarde (BE)
(72) Inventor: Colson, Paul Frans Marie, 9880 Lotenhulle (BE); Boonen, Sylvie, 9051 Gent - St. Denijs-Westrem (BE); De Backer, Eddy, 9820 Merelbeke (BE); De Pestel, Freddy Marcel Yvan, 9080 Lochristi (BE); Moens, Peter Dominique Willem, 9620 Zottegem (BE); Tack, Marnix Roger Anna, 9820 Merelbeke (BE); Villanueva, Davy Fabien Michel, 58999 Lille (FR)
(74) Representative: Bird, William Edward

(57) **Abstract**

A method for processing a low ohmic contact structure to a buried conductive layer in or below a device layer forming part of a semiconductor component is presented, whereby first a highly doped region within said device layer reaching said buried conductive layer is realised, this being followed by a step of etching a trench through said highly doped region to a final depth which extends at least to the semiconductor substrate underneath said buried conductive layer. In a variant method this trench is first pre-etched until a predetermined depth, before the highly doped region is provided.

A semiconductor structure which is realised by these methods is described as well.

## Description

The present invention relates to a method for processing a low-ohmic contact structure to a buried layer as is further described in the preamble of the first claim.

Buried layers are usually present in high-voltage or bipolar device structures and serve a.o. to create vertical devices such as DMOS transistors, or to lower the collector resistance in bipolar transistors. In classical bulk silicon processing, these buried layers are created by means of a high dose ion implantation into the semiconductor substrate, followed by a subsequent anneal. After formation of the buried layer, an epitaxial layer also called a device layer, is usually grown on the wafer. In this epitaxial silicon layer, hereafter abbreviated by epi-layer, the active devices will be further realized. The final thickness of such epi layers may vary from 1µm in high-speed bipolar processes to 3-5 µm in high voltage bipolar and DMOS processes to even 10-20 µm in very high-voltage processes .

One of the necessary processing steps during the subsequent processing of the active devices such as the bipolar or MOS devices, consists in providing a structure for realizing a low-ohmic contact to these buried layers

A first category of known methods for realizing such low-ohmic contacts to buried layers comprise the use of sinkers. These are made by a high dose, high energy ion implantation in the semiconductor substrate , followed by an annealing step at an elevated temperature, for a time sufficient to allow the implanted dopant atoms to reach the buried layer by diffusioin. The large thermal budget may however cause unwanted diffusion in other layers, and is not desirable in a scaled back process. Furthermore the requirement for deep diffusion may cause lateral diffusion of the implanted sinker which substantially increases the area of the sinker and thus increases lateral dimensions.

Other known methods, mainly developed to overcome the abovementioned problems associated to the classical sinker structure, include the processing of a trench structure extending to the buried layer, with sidewalls of the trench region being lined with dielectric and with a conductive material filling the trench and forming an electrically conductive contact with the buried layer. This approach is for instance described in US patent 5 614 750.

This method however introduces additional complexity to the complete process flow since, besides providing the aforementioned trench for making the contact to the buried layer, another trench for isolating device structures from each other is also to be provided using separate processing steps. In addition, doubling the amount of trenches introduces additional mechanical stress into the wafer, having yield and reliability problems as a consequence.

Other approaches for realizing a contact to the buried layer are described in US patents 6 326292 and 5856700. Both make use of existing trench regions for isolation and provide highly doped regions surrounding these trench isolation regions, and which extend into the buried layer. In US 6 326292 this is achieved by means of providing a layer of a material, such as polysilicon, in which dopants diffuse faster than in the surrounding epi layer, on the walls of the trench. In US 5856700, also a polysilicon layer is present in the sidewall of the trench; in the latter patent outdiffusion from dopant atoms from this polysilicon layer into the surrounding epi is used for realising a low-ohmic region in the epi layer to the buried layer. In US 6326292 the faster vertical diffusion of the dopants in this polysilicon layer, with respect to the surrounding epi layer, is used for realising a highly-doped low-ohmic region surrounding the trench and for reaching through the epi to the buried layer.

Drawbacks of these methods are however that, in case a polysilicon layer is used merely as an outdiffusion region, extra space is needed for the provision of this region. In the case of a polysilicon layer used as low-ohmic contact region, this problem is not present. However in both approaches a separate doping region is still needed for enabling the contacts with a metal. Moreover, both approaches are described for silicon-on-insulator applications. The use of these techniques in classical bulk Silicon processing is however not possible since the etching of the polysilicon layer at the bottom of the trench, as is done in both techniques , would result in a short circuit in classical bulk silicon technologies, whereas in silicon-on-insulator technologies the intrinsic insulating layer inherent to silicon-on-insulator wafers and lying beneath the trench, provides for electrical isolation between the regions surrounding the trench.

An object of the present invention is thus to provide a method for providing a buried layer contact structure but which solves the aforementioned problems of lateral space consumption, processing complexity and which is at the same time feasible in classical bulk semiconductor technology.

According to the invention, this object is obtained as is described in claim 1.

In this way, the processing steps necessary for realizing a trench region for isolation purposes are combined with these for generating a lowly doped region surrounding the trench and extending to the buried layer. The etching of the trench is done after the doping step in contrast to the prior art methods. The present approach is very simple and results at the same time in the provision of a low-ohmic, highly doped diffusion region for the buried layer contact, and a trench region having a high-voltage insulating capability . Furthermore this technique can be applied in classical bulk semiconductor technologies since the etching of the trench after the doping of the low-ohmic region allows to etch the trench deep into the substrate, thus also beyond the buried layer, thereby further enhancing electrical isolation. An additional advantage of the present technique is that this approach allows an unmasked buried layer implantation, in contrast to what is used in classical bulk semiconductor technologies, thus again simplifying the complete process flow.

Another characteristic feature of the present invention is described in claim 2.

By the use of the same mask for the definition of both the low-ohmic diffusion region as well as the trench , process complexity is still further reduced.

The use of an oxide layer or a stack layer comprising an oxide as top layer for this masking layer has the further advantage of providing a very high selectivity during the subsequent etching of the silicon trench.

Yet another characteristic feature of the present invention is mentioned in claim 4.

The use of a polysilicon layer allows for a better dimensional control during the subsequent etching of the trench as will be more explained into depth in the descriptive portion of this document.

A further characteristic feature of the present invention is described in claim 5.

This is especially suitable for thick epi-layers whereby a pre-etching of the trench allows the subsequent doping step of the highly doped region serving as low-ohmic diffusion region for contacting the buried layer, to be as short as possible. This again has the advantage of providing a tight dimensional control, since a longer time needed for vertical diffusion of the dopant atoms also results in a larger lateral outdiffusion of these atoms, which is not desirable. A pre-etch of the trench until a first predetermined depth thus allows to tightly control the lateral dimensions of the surrounding low-ohmic diffusion region. Indeed, the pre-etching of the trench itself results in a much lower thermal budget needed for the dopant atoms to reach the buried layer since the vertical distance these atoms have to move is considerable reduced due to the first trench.

Another characteristic feature of the present invention is mentioned in claim 6.

This provides a minimum requirement for the depth to which the trench is to be etched during the pre- etching step.

An additional characteristic feature of the present invention is mentioned in claim 7.

The doping through the polysilicon layer again provides the advantage of better dimensional control during the subsequent further etching of the trench.

Yet another characteristic feature of the present invention is described in claim 8.

This method can thereby be used in a lot of different semiconductor processes, whereby the depth of the trench determines inter alinea a desired breakdown voltage between two buried layers separated by this trench. This breakdown voltage is further increased by the addition of a stopper implant region beneath the trench, as is mentioned in claim 9.

The invention relates as well to the devices which are obtained by means of the aforementioned methods, these devices being described in claims 10 and 11.

These and other objects, advantages and features of the invention will become apparent from the following description thereof taken in conjunction with the accompanying drawings in which
Fig. 1 is a cross-sectional view of a trench insulating structure according to the invention,
Figs. 2a-d are cross-sectional views of parts of a semiconductor wafer indicating the different processing steps for a first variant method for manufacturing of the structure as depicted in Fig. 1, and
Figs. 3a-d are cross-sectional views of parts of a semiconductor wafer indicating the different processing steps for a second variant method for the manufacturing of a structure according to the invention.

The present invention is amongst others used in classical bulk silicon processing, but may as well be applied to other semiconductor processes such as III-V or IV-IV processes, and intends to provide at the same time a device for electrically insulating different regions from each other, while also providing a low-ohmic contact to an underlying highly doped buried layer. The remainder of this text will describe classical bulk silicon processing, but the principles are as well applicable to other semiconductor processes.

Until now, high voltage and high speed bipolar bulk silicon processes made use of sinker plugs to contact this buried layer. However processing of sinker plugs requires several lithographic steps, which makes the process more expensive. Furthermore these plugs consume a lot of lateral space, especially when these plugs are also used for junction isolation of high voltage regions.

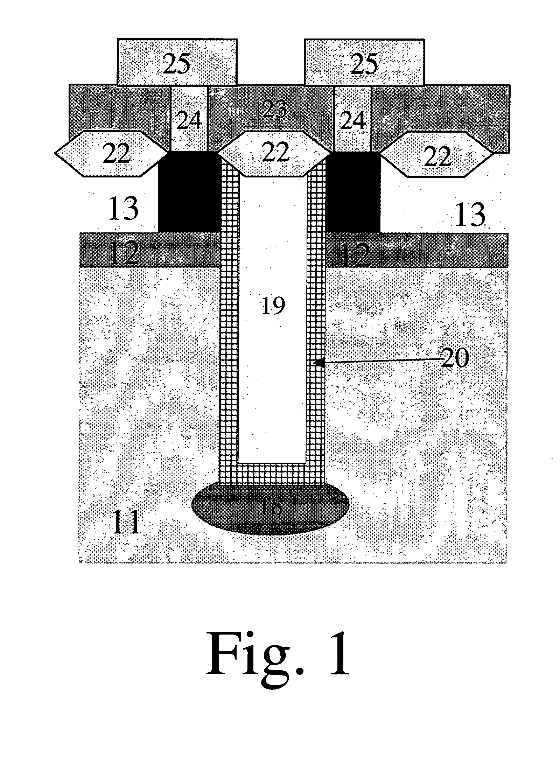

The present semiconductor structure, depicted in Fig. 1, eliminates the use of such sinker and thereby provides for a considerable reduction in area consumption. This structure includes a deep trench region 19, having a final depth depending on the maximum applied voltage between surrounding buried layer regions 12, and extending into in the bulk or substrate silicon region 11 beyond the lower depth boundary of this buried layer 12. The trench has oxidized sidewalls 21, and is filled with a filler material such as polysilicon or dielectric materials such as oxides ( Boron Phosphorus Silicate Glass, abbreviated by BPSG, tetra ethyl ortho silicate, abbreviated by TEOS ), oxynitrides or nitrides. Above the buried layer 12, the trench is surrounded by a highly doped region 16 within an epi layer or device layer 13. Moreover this highly doped region can be directly contacted by metal as was the case with classical sinkers. These contacts are schematically depicted as plugs 24, for instance W-plugs, on which a first metal layer 25, is deposited and etched such as to realise the further interconnection from the buried layer to other structures on the integrated circuit. Figure 1 further shows a stopper implant region 18 beneath the trench, as well as a classical field oxide 22 which is applicable in silicon semiconductor processing.

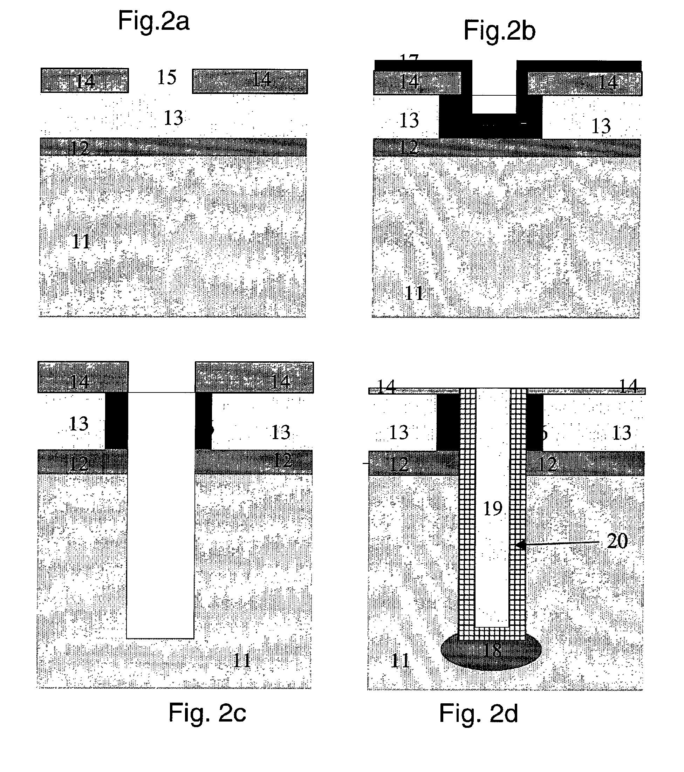

Figs 2a-d will explain the different processing steps for the realisation of such a structure . A first embodiment of the subject semiconductor structure will be described for use in a high voltage DMOS process with breakdown voltage of 80 V . However, the basic structure is as well suited to be used in a lot of other processes ranging from low voltage, high speed bipolar process to other high voltage processes, whether in silicon or whether in another semiconductor material. The different embodiments will result from different etching and dopant conditions such that the resultant geometries can also be different in these different applications. However the basic processing steps as well as the basic trench semiconductor structure will be basically the same in all process applications and will be described more into detail below. Particular details of implantation conditions, deposition thicknesses, and dimensions, will of course vary also from the ones hereafter described for these high voltage structures, as compared to these in other processes, as mentioned before. Nevertheless the basic sequence of processing steps will remain the same for all processes and is given hereafter.

Fig. 2a shows a silicon wafer 11, in which a buried layer 12, typically having a thickness of 2 µm, is covered by an epitaxial layer 13, typically having a thickness of 5 µm. An n-type buried layer on top of a p-type silicon substrate may be realised by means of a masked or non-masked implantation of Arsenic or Antimony atoms, followed by a high-temperature drive-in step. However the invention is as well applicable to p-type buried layers lying in an n-type substrate or to both types of buried layers, which are then realised by masked implantations, in either type of substrate. P-type buried layers are realised by a non-masked or masked implantation of Boron atoms followed by a high-temperature drive-in step. In the remainder of this document the description will be given for an n-type buried layer with a p-type epi on top of it. However the invention is as well applicable to p-type buried layers with an n-type epi layer on top.

An additional advantage of the present structure is that it allows the implantation of the buried layer to be performed as a non-masked one, in the case of only one buried layer present since the present structure provides for an inherent isolation between surrounding buried layers.

After the realisation of the n-type buried layer an in-situ doped p-type epitaxial silicon layer of a thickness of 8 µm is deposited on top of the wafer, for 80 V applications. Due to further outdiffusion of the buried layer during subsequent processing steps, the effective epi-layer thickness will be further reduced, to a typical value of 5 µm for 80 V applications. For lower maximum voltage , a lower epi-thickness can be used such as to result in a final epi thickness of 3 µm for maximum voltage applications of 50 V.

The construction of the semiconductor structure according to the invention starts with the deposition of a stack layer consisting of a TEOS layer of approximately 1 µm on top of a nitride layer of approximately 200 nm, which is itself lying on top of a thin pad oxide of 20 nm. The total sandwich layer is denoted 14 in Figs 2a to 2d. Next a so-called hard mask is defined in this sandwich layer by means of photolithography and subsequent etching, such that an opening is defined in the layer at the regions where the trench is to be located. This step is called the hard-mask definition and is shown in Fig. 2a as the opening 15 in the layer 14. Next, a first etching or pre-etching of the trench is performed. In a preferred embodiment this first etching is done until a depth which almost extends to the top of the buried layer. However, other embodiments of the semiconductor structure may have trenches whereby the first etching step extends beyond the buried layer. In any case the first etching needs to be performed to a minimum depth which is defined as the upper boundary of the buried layer minus a vertical outdiffusion distance of a dopant of the region 16 which will surround the trench. This outdiffusion distance will be discussed in a next paragraph.

The first etching of the trench is followed by a cleaning step. Next a highly doped region surrounding this trench is to be processed. This may be done directly via a doping step , for instance by an in-situ doping in POCI3. However in a variant of the method, first a thin polysilicon layer 17 is deposited within the trench, this polysilicon layer having a thickness of typically 50 nm. Next this polysilicon layer as well as the silicon layer beneath it, is doped . For an n-type buried layer lying in a p-type substrate, and on which a p-type epi layer is deposited, the low-ohmic diffusion region for contacting the buried layer has to be n-type. Such an n-type region can be realised by means of an ion-implantation step of Arsenic or Phosphorus, followed by a subsequent high temperature anneal. In a preferred embodiment, a POCL3 doping is used. As is well known such a POCl3 doping consists of a two-step process : first a phosphorus-glass P2O5 layer will be deposited on the wafer during a high temperature step (not shown on Fig. 2b), thereby consuming already a large part of the thin polysilicon layer 17, and during a next high-temperature drive-in step the Phosphorous atoms of this Phosphorus-glass layer will further diffuse into the surrounding silicon through the small polysilicon region . The thus obtained highly doped n+ region is denoted 16 on Fig. 2b, whereby this region is vertically reaching the buried layer. The lateral outdiffusion width of this region is typically 3 µm wide from the trench edges to the lateral edge of the n+ region itself. The vertical outdiffusion width might differ from this width due to stress induced by the trench, and is the minimum width which needs to be taken into account for defining the under boundary for realising the first etching of the trench. So for a final epi thickness of 5 µm and a vertical outdiffusion depth of 2 µm a first etching of the trench to approximately 3 µm would be sufficient.

In a next step the formed phosphorus glass is etched. The remaining small polysilicon layer is thereby acting as a protecting layer for the hard mask, such that this hard mask will not suffer from the oxide etch of the phosphorus glass. Thus dimensional control is kept. In the aforementioned other variant of the method the previous polysilicon deposition could be avoided before the doping of the n+ layer 16, but in this case the etching step of the phosphorous glass will also etch part of the TEOS hard mask such that during the next etching step of the trench, the resulting trench will be broader.

For the case of a p-type buried layer, a highly doped p-type region has to be realised. This is for instance done via an in-situ doping of the polysilicon, followed by a drive-in step.

As thus mentioned, after the removal of the P2O5 glass, in case of an n-type doping, the trench is further etched deeper, still using the remaining hard-mask which was still intact due to the protective thin polysilicon layer. The final depth to which the trench is to be etched is a function of the maximum voltage difference across neighbouring buried layers and devices on both sides of the trench. For a typical voltage difference of 50 V, a total trench depth of 7 to 8 µm is used. For a voltage difference of 80 V, a total trench depth of 11 to 13 µm is needed. In any case the final trench depth has reach the underlying substrate, i.e. the lower edge of the buried layer, such as to provide this high voltage isolation capability. However, the deeper the trench is etched in the substrate, the better the high voltage isolation capabilities will be.

Apart from the trench final depth the breakdown voltage is also dependent on other parameters such as the doping concentration of the epi-layer and the substrate layer, as well as of an additional stopper implant region which will be discussed in the next paragraph.

The structure realised until then is depicted in Fig. 2c.

Next, the isolation properties of the trench region are further enhanced by means of a stopper implant . This will increase the field threshold voltage of the parasitic transistor beneath the trench. For a bulk silicon wafer of p-type material, this field threshold is enhanced by implanting p-type atoms such as Boron atoms. For the bulk silicon wafer consisting of n-type material, the field threshold voltage is enhanced by means of implanting n-type atoms such as Phosphorous or Arsenic atoms. A high voltage ion implantation step is thereby performed through a first grown sacrifical screen oxide of typically 50 nm thickness (not shown on Fig. 2d) which is deposited after final etching and cleaning of the trench. This sacrificial oxide serves to avoid implantation damage during the next ion implantation. The hard-mask layer 14, still lying on top of the wafer, again defines the regions intended to implant for increasing the field threshold. The resulting so-called stopper implant region is denoted 18 on Fig. 2d and on Fig. 1.

After this stopper implantation the 1 µm TEOS layer of the hard mask stack is removed therefrom, leaving only the nitride and pad oxide with the hard mask defined. At the same time as the removal of the TEOS layer also the thin screen oxide is also removed. This is followed by a liner oxidation step such as to further cover the inner walls of the trench with an oxide 20 having a thickness of typically 150 nm. The function of this oxide is for further isolation purposes. This oxide has to withstand the lateral voltage drop, keep the electrical field in the vicinity of the trench below the critical level associated to the maximum breakdown voltage, offer a good Si/SiO2 interface quality in order to minimize the leakage current and on the other hand it increases the threshold voltage of the parasitic transistor formed during the subsequent filling of the trench with polysilicon. The hard nitride mask again serves as a protection such as to only oxidize the trench walls and not the rest of the silicon wafer. Finally the trench is filled with a typical filler material such as polysilicon 19, after which all polysilicon that is further lying on the non-trench regions as a result of this deposition, is etched back by a selective etching step such as to avoid etching of the polysilicon in the trench. The resulting structure is thus depicted in Fig. 2d.

Finally the nitride layer of the hard mask is completely removed and standard further processing continues with for instance the active area definition and growth of the field oxide 22 as depicted in Fig. 1. The structure in Fig. 1 further shows metal contacts to the highly doped region 16 via plugs 24 in an interlayer dielectric 23 . These plugs may be filled with W or another material. Finally contacting the regions 16 is accomplished by the deposition and etching of a first metal interconnect layer 25.

Of course more metal interconnect layers can be present as well as polysilicon gate regions and highly doped source/drain/emitter regions. Since however these regions are not relevant to the present invention and in order not to overload the drawings, these layers are omitted in the figures.

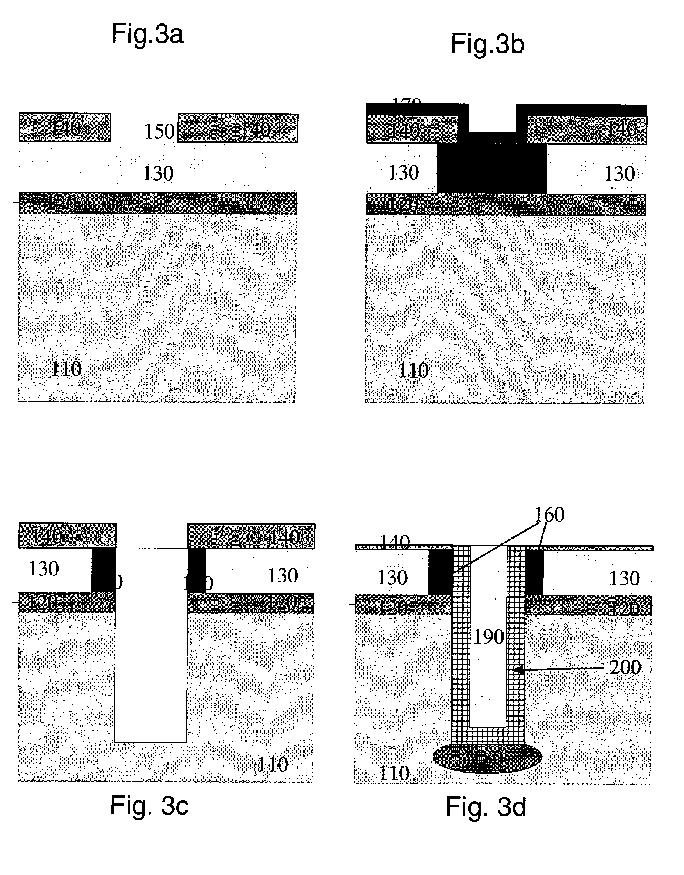

In the case of thinner epi layers, whereby the diffusion of the Phosphorus atoms is such that these easily reach the buried layer from the surface of the wafer during the conventional POCI3 doping, the first etching of the trench may be omitted. This is schematically shown in Figs. 3a-d which mainly show the same processing steps as these of Figs. 2a-d, except for the pre-etching of the trench. Thus first the hard mask 140-150 is defined on top of an epi-layer 130, which itself is deposited on top of a buried layer 120 in a silicon substrate 110. An additional polysilicon layer 170 may be beneficial for the same reasons previously mentioned, but may also be omitted in case of doping via ion implantation and subsequent anneal. The resulting doping layer 160 is then reaching the buried layer , for instance for epi-layers not thicker than 3 µm. Next, as shown in Fig. 3c, the trench is etched at once, for instance to a depth of 7 to 8 µm for 50 V applications. After this, the same processing steps as shown in Fig. 2d will also be applied as shown in Fig. 3d : stopper implantation 180 , trench sidewall oxidation 200, trench filling with polysilicon and subsequently the further classical processing for the realisation of the active device.

While the principles of the invention have been described above in connection with specific apparatus, it is to be clearly understood that this description is made only by way of example and not as a limitation on the scope of the invention, as defined in the appended claims.

## Claims

1. Method for processing a low ohmic contact structure to a buried conductive layer in or below a device layer forming part of a semiconductor component, said method comprising a step of providing a highly doped region within said device layer reaching said buried conductive layer
**characterized in that**
said step of providing said highly doped region is followed by a step of etching a trench through said highly doped region to a final depth which extends at least to the semiconductor substrate underneath said buried conductive layer.

2. Method according to claim 1
**characterised in that**
said highly doped region is provided by means of a high-temperature doping step through an insulator masking layer,
whereby said insulator masking layer is also used for defining said trench region.

3. Method according to claim 2
**characterised in that**
said insulator masking layer includes an oxide layer as top layer.

4. Method according to claim 2
**characterised in that**
said high-temperature doping step is performed through a polysilicon layer which is deposited on top of said insulator masking layer.

5. Method according to claim 1
**characterised in that**
said step of providing said highly doped region is preceded by a step of pre-etching said trench region until a predetermined depth which is less deep than said final depth.

6. Method according to claim 5
**characterised in that**
said predetermined depth is at minimum the depth of the upper edge of said buried layer minus the vertical outdiffusion depth of said highly doped region .

7. Method according to claims 4 and claims 5
**characterised in that**
said pre-etching of said trench region is followed by the deposition of said polysilicon layer, whereby said highly doped region is provided through diffusion of a dopant through said polysilicon layer into said device region.

8. Method according to any of the previous claims
**characterised in that**
said final depth of said trench is related to the maximum breakdown voltage between two buried layer regions separated by said trench .

9. Method according to claim 9
**characterised in that**
said etching of said trench until said final depth is followed by a step of providing a stopper implant region beneath said trench
whereby said maximum breakdown voltage is further determined by said stopper implant region.

10. Semiconductor structure including a trench in a device layer on top of a buried layer, said trench extending at least through said buried layer to a semiconductor substrate beneath said buried layer, said trench being surrounded by a doped region which vertically extends at least to the upper edge of said buried layer and which has a doping concentration which is higher and of opposite type than the doping concentration of said device layer.

11. Semiconductor structure according to claim 10
**characterised in that**
said semiconductor structure further includes a highly doped stopper implant region beneath said trench in said semiconductor substrate.
